(19) **Europäisches Patentamt**
**European Patent Office**
**Office européen des brevets**

(11) **EP 1 429 152 B1**

(12) **EUROPÄISCHE PATENTSCHRIFT**

(45) Veröffentlichungstag und Bekanntmachung des Hinweises auf die Patenterteilung:
**12.12.2007  Patentblatt 2007/50**

(51) Int Cl.:
**G01R 31/36** *(2006.01)*

(21) Anmeldenummer: **03021341.7**

(22) Anmeldetag: **20.09.2003**

(54) **Verfahren zur Vorhersage des Innenwiderstands einer Speicherbatterie und Überwachungseinrichtung für Speicherbatterien**

Method for predicting the internal resistance of a battery and a monitoring device for batteries

Méthode de prédiction de la résistance intérieure d'une batterie et un dispositif de surveillance pour batteries

(84) Benannte Vertragsstaaten:
**AT BE BG CH CY CZ DE DK EE ES FI FR GB GR HU IE IT LI LU MC NL PT RO SE SI SK TR**

(30) Priorität: **13.11.2002  DE 10252760**

(43) Veröffentlichungstag der Anmeldung:
**16.06.2004  Patentblatt 2004/25**

(73) Patentinhaber: **VB Autobatterie GmbH & Co. KGaA**
**30419 Hannover (DE)**

(72) Erfinder: **Laig-Hörstebrock, Helmut, Dr. Dipl.-Phys.**
**60320 Frankfurt (DE)**

(74) Vertreter: **Gerstein, Hans Joachim et al**
**Gramm, Lins & Partner GbR**
**Theodor-Heuss-Strasse 1**
**38122 Braunschweig (DE)**

(56) Entgegenhaltungen:
**WO-A-03/001224          DE-A- 19 847 648**
**US-A- 6 167 349**

• **HERON R ET AL: "Evaluation of conductance and impedance testing on VRLA batteries for the Stenter Operating Companies" TELECOMMUNICATIONS ENERGY CONFERENCE, 1994. INTELEC '94., 16TH INTERNATIONAL VANCOUVER, BC, CANADA 30 OCT.-3 NOV. 1994, NEW YORK, NY, USA,IEEE, 30. Oktober 1994 (1994-10-30), Seiten 270-281, XP010136434 ISBN: 0-7803-2034-4**

**Beschreibung**

Die Erfindung betrifft ein Verfahren zur Vorhersage des Innenwiderstandes einer Speicherbatterie bei angenommenen Umgebungs- und Batteriezustandsbedingungen.

Die Erfindung betrifft weiterhin eine Überwachungseinrichtung für Speicherbatterien mit Messmitteln zur Messung von Parametern der Umgebungs- und Batteriezustandsbedingungen, der Speicherbatterie und mit Rechenmitteln.

Die Erfindung betrifft weiterhin ein Erzeugnis in Form eines verkörperten Computerprogramms mit Programmcodemitteln zur Durchführung des oben genannten Verfahrens.

Bei dem Betrieb von Speicherbatterien, insbesondere von Starterbatterien in Kraftfahrzeugen, besteht ein Bedarf den momentanen Zustand der Speicherbatterie zu bestimmen und einen zukünftigen Zustand bei angenommenen Umgebungs- und Batteriezustandsbedingungen vorherzusagen. Beispielsweise ist es erwünscht, die Startfähigkeit einer Starterbatterie zum Anlassen eines Verbrennungsmotors unter angenommenen Temperaturverhältnissen zur ermitteln. Hierzu ist bekannt, den aktuellen Innenwiderstand zu bestimmen. Dies kann beispielsweise aus dem Spannungseinbruch beim Start als Quotient aus der Spannungsänderung zur Stromänderung erfolgen. Der Innenwiderstand kann auch durch Anpassung der Spannungs- und Strominformation der Speicherbatterie an ein komplexeres Ersatzschaltbild gewonnen werden. Ein solchermaßen ermittelter Innenwiderstand kann dann als Prognose für einen kommenden Startvorgang verwendet werden.

In der DE 198 47 648 A1 ist ein Verfahren zur Bestimmung des Ladezustands und der Hochstrombelastbarkeit von Batterien offenbart, bei dem der Innenwiderstand der Batterie durch eine Spannungs- und Strommessung bei hoher Belastung, beispielsweise beim Startvorgang, bestimmt wird. Weiterhin wird in einem ersten Zustand der Ladezustand SOC der Speicherbatterie ermittelt. Dies erfolgt beispielsweise durch Messen der Ruhespannung. Der Innenwiderstand ist in einem vom Ladezustand fast unabhängigen nur temperaturabhängigen Teil und einen für Ladezustände kleiner als 50% stark mit dem Ladezustand veränderlichen Anteil aufgeteilt. Aus dem derart aufgeteilten Innenwiderstand einer vorgegebenen Temperatur und dem zuletzt ermittelten Ladezustand wird eine Ruhespannung für einen späteren Zeitpunkt prognostiziert, aus der mit dem bekannten zum Start eines Verbrennungsmotors notwendigen Stroms eine Aussage über die Startfähigkeit der Speicherbatterie abgeleitet werden kann.

Aus der WO 03001224 A1 ist eine Aufleitung des Innenwiderstandes in einen Widerstand für die elektrische Leitung und für die Ionenleitung bekannt.

Aufgabe der Erfindung ist es, ein verbessertes Verfahren zur Vorhersage des Innenwiderstandes einer Speicherbatterie bei angenommenen Umgebungs- und Batteriezustandsbedingungen zu schaffen, mit dem beispielsweise die Startfähigkeit einer Starterbatterie eines Kraftfahrzeuges für einen späteren Zeitpunkt vorhersagbar ist, zu dem sich die Temperatur und/oder der Ladezustand der Speicherbatterie z. B. durch Ruhestromverbraucher deutlich verändert hat.

Die Aufgabe wird mit dem Verfahren erfindungsgemäß gelöst durch:

- Aufteilen des Innenwiderstandes mindestens in einen ersten Widerstandsanteil, der den elektrischen Widerstand der Speicherbatterie für den Bereich der Elektronenleitung repräsentiert, und einen zweiten Widerstandsanteil, der den elektrischen Widerstand der Speicherbatterie für den Bereich der Ionenleitung repräsentiert, und

- Ermitteln der bei den angenommenen Umgebungs- und Batteriezustandsbedingungen zu erwartenden Widerstandsanteile jeweils in Abhängigkeit von Parametern der angenommenen Umgebungs- und Batteriezustandsbedingungen.

Es wurde erkannt, dass die Abhängigkeiten des Innenwiderstandes insbesondere von dem Ladezustand und der Temperatur als Parameter der Umgebungs- und Batteriezustandsbedingungen für die metallischen Ableiter, d. h. für den Bereich der Elektronenleitung sehr verschieden von dem Innenwiderstand für die Elektrolyten, d. h. für den Bereich der Ionenleitung sind. Dabei sind für den ersten Widerstandsanteil der metallischen Ableiter und den zweiten Widerstandsanteil der Elektrolyten jeweils relativ einfache funktionale Zusammenhänge mit den Parametern der Umgebungs- und Batteriezustandsbedingungen vorhanden. Durch die Trennung des Innenwiderstands in den ersten und zweiten Widerstandsanteil wird die komplexe Abhängigkeit des Innenwiderstands von Umgebungs- und Batteriezustandsbedingungen aufgelöst und in einfache funktionale Zusammenhänge zerlegt.

Vorteilhafterweise werden die Widerstandsanteile jeweils aus einem Faktor multipliziert mit einer batterieunabhängigen Funktion berechnet. Der erste Faktor für den ersten Widerstandsanteil und der zweite Faktor für den zweiten Widerstandsanteil wird hierbei in Abhängigkeit von dem Typ der Speicherbatterie festgelegt oder ermittelt. Der erste Widerstandsanteil wird dann aus dem ersten Faktor und einer batterieunabhängigen ersten Funktion von Parametern der Umgebungsbedingungen der Speicherbatterie und der zweite Widerstandsanteil aus dem zweiten Faktor und einer batterieunabhängigen zweiten Funktion von Umgebungs- und Batteriezustandsbedingungen der Speicherbatterie bestimmt. Damit müssen nur noch die ersten und zweiten Faktoren für die Speicherbatterie festlegt oder erlernt werden. Die erste und zweite Funktion hingegen sind unabhängig von dem Batterietyp und können damit generell ermittelt und festgelegt werden. Damit ist eine Vorhersage des Innenwiderstands auch bei unbekannten Speicherbatterien möglich, sobald lediglich die ersten und zweiten Faktoren batterietypabhängig erlernt wurden.

Das Ermitteln des ersten und zweiten Faktors erfolgt vorzugsweise durch Bestimmen von Parametern und Innenwiderständen bei mindestens zwei voneinander verschiedenen Umgebungs- und/oder Batteriezustandsbedingungen. Nach Schätzung eines der Faktoren und Bestimmung der Parameter bei zwei voneinander verschiedenen Umgebungs- und/oder Batteriezustandsbedingungen, insbesondere bei zwei unterschiedlichen Temperaturen, ist das System ausreichend bestimmt, um den ersten und zweiten Faktor mit ausreichender Genauigkeit zu berechnen.

Als Parameter zur Ermittlung des ersten Widerstandsanteils wird vorzugsweise eine zur Batterietemperatur proportionale Größe genutzt. Als Parameter zur Ermittlung des zweiten Widerstandsanteils wird vorzugsweise eine zur Batterietemperatur proportionale Größe und eine zum Ladezustand der Speicherbatterie proportionale Größe eingesetzt. Als Temperaturparameter, d. h. als eine zur Batterietemperatur proportionale Größe, kann beispielsweise die Batterie- oder Umgebungstemperatur gemessen werden. Die zum Ladezustand der Speicherbatterie proportionale Größe ist vorzugsweise die Ruhespannung der Speicherbatterie. Weiterhin wird als Parameter noch der Innenwiderstand der Speicherbatterie in bekannter Weise ermittelt.

Der erste und zweite Faktor wird vorzugsweise mit den folgenden Schritten iterativ ermittelt:

a) Schätzen des ersten Faktors,

b) Bestimmen des zweiten Faktors in Abhängigkeit von dem geschätzten ersten Faktor und von Parametern, die bei ersten Umgebungs- und Batteriezustandsbedingungen ermittelt wurden,

c) Bestimmen eines korrigierten ersten Faktors bei veränderten zweiten Umgebungs- und/oder Batteriezustandsbedingungen in Abhängigkeit von dem vorher ermittelten zweiten Faktor und den bei den zweiten Umgebungs- und Batteriezustandsbedingungen ermittelten Parametern;

d) Bestimmen des zweiten Faktors in Abhängigkeit von dem korrigierten ersten Faktor und den bei den ersten oder zweiten Umgebungs- und Batteriezustandsbedingungen ermittelten Parametern.

Dabei können die Schritte c) und d) zur Erhöhung der Genauigkeit der ersten und zweiten Faktoren beliebig oft wiederholt werden.

Mit den solchermaßen bestimmten ersten und zweiten Faktoren wird der erste Widerstandsanteil nach der Formel

$$R_{Met} = Rfakt_{Met}(T_0) \cdot r(T)$$

ermittelt, wobei $Rfakt_{Met}(T_0)$ der erste Faktor bei einer Referenztemperatur $(T_0)$ und $r(T)$ eine von der Batterietemperatur $T$ abhängige erste Funktion ist.

Die erste Funktion $r(T)$ kann beispielsweise als Gleichung

$$r(T) = 1 + k \cdot (T - T_o) + l(T - T_0)^2$$

mit den Konstanten k und l definiert sein. Für einen Bleiakkumulator mit sechs Zellen kann die Konstante k beispielsweise 0,00334 und die Konstante l gleich null betragen.

Der zweite Widerstandsanteil wird beispielsweise nach der Formel

$$R_{EM} = 1/(\, Lfakt \cdot f(T, SOC)\,)$$

ermittelt, wobei Lfakt der zweite Faktor und $f(T, SOC)$ eine von der Batterietemperatur $T$ und dem Ladezustandsparameter SOC der Speicherbatterie abhängige zweite Funktion ist.

Die zweite Funktion $f(T, SOC)$ kann beispielsweise als Gleichung

$$f(T,SOC) = (a + b \cdot SOC + c \cdot SOC^2) \cdot (1 + d(T - T_0) + e(T - T_0)^2)$$

mit den Konstanten a, b, c, d und e und der Referenztemperatur $T_0$ definiert sein. Für eine Bleibatterie mit sechs Zellen beträgt die Konstante a vorzugsweise etwa 0,451, die Konstante b vorzugsweise etwa 1,032, die Konstante c vorzugsweise etwa -0,697, die Konstante d vorzugsweise etwa 0,0137 und die Konstante e vorzugsweise etwa 0. Als Referenztemperatur wird vorzugsweise 25°C festgelegt.

Um Unsicherheiten beispielsweise aufgrund Messungenauigkeiten und damit verbundenen Streuungen berücksichtigen zu können, wird der erste Faktor vorzugsweise durch Bestimmen eines aktuellen ersten Faktors bei aktuellen Umgebungs- und Batteriezustandsbedingungen und Berechnen des korrigierten ersten Faktors aus dem aktuellen ersten Faktor und mindestens einem gewichteten vorher bestimmten ersten Faktor korrigiert. Entsprechend kann auch der zweite Faktor durch Bestimmen eines aktuellen zweiten Faktors bei aktuellen Umgebungs- und Batteriezustandsbedingungen und Berechnen des korrigierten zweiten Faktors aus dem aktuellen zweiten Faktor und mindestens einem gewichteten vorher bestimmten zweiten Faktor korrigiert werden. Die aktuell ermittelten ersten und zweiten Faktoren werden somit nicht direkt übernommen. Vielmehr bleibt ein gewichteter Einfluss von früher bestimmten Faktoren erhalten.

Der erste Faktor für die Referenztemperatur $T_0$ wird vorzugsweise nach der Formel

$$Rfakt_{Met}(T_0) = \frac{R_1 \cdot f(T_1, SOC_1) - R_2 \cdot f(T_2, SOC_2)}{r(T_1) \cdot f(T_1, SOC_1) - r(T_2) \cdot f(T_2, SOC_2)}$$

berechnet, wobei $R_1$ der Innenwiderstand, $T_1$ die Batterie- oder Umgebungstemperatur und $SOC_1$ der Ladezustandsparameter zum Zeitpunkt einer ersten Messung bei ersten Umgebungs- und Batteriezustandsbedingungen und $R_2$ der Innenwiderstand, $T_2$ die Batterie- oder Umgebungstemperatur und $SOC_2$ der Ladezustandsparameter zum Zeitpunkt einer zweiten Messung bei zweiten Umgebungs- und Batteriezustandsbedingungen sind.

Der zweite Faktor wird vorzugsweise nach der Formel

$$Lfakt = 1/([R_i - Rfakt_{Met}(T_0) \cdot r(T_i)]f(T_i, SOC_i))$$

berechnet werden, wobei $R_i$ der Innenwiderstand, $T_i$ die Batterie- oder Umgebungstemperatur und $SOC_i$ der Ladezustandsparameter zum Zeitpunkt i einer Messung sind.

Besonders vorteilhaft ist es, den Innenwiderstand weiterhin neben dem ersten und zweiten Widerstandsanteil in einen dritten Widerstandsanteil für den Bereich der positiven aktiven Masse der Speicherbatterie und/oder in einen vierten Widerstandsanteil für den Bereich der negativen aktiven Masse der Speicherbatterie aufzuteilen und den dritten und/oder vierten Widerstandsanteil entsprechend des oben beschriebenen Verfahrens jeweils mit einem zugeordneten Faktor und einer zugeordneten Funktion in Abhängigkeit von Parametern der Umgebungs- und Batteriezustandsbedingungen zu ermitteln.

Aus dem vorhergesagten Innenwiderstand erfolgt vorzugsweise eine Vorhersage des Zustands der Speicherbatterie, beispielsweise des Verschleisses, der Leistungs- oder der Funktionsfähigkeit der Speicherbatterie.

Die Aufgabe wird weiterhin durch eine Überwachungseinrichtung für Speicherbatterien mit Messmitteln zur Messung von Parametern der Umgebungs- und Betriebszustandsbedingungen der Speicherbatterie und mit Rechenmitteln gelöst, die zur Durchführung des oben beschriebenen Verfahrens ausgebildet sind. Die Rechenmittel können beispielsweise als Prozessoreinrichtung mit auf der Prozessoreinrichtung laufenden Computerprogrammen realisiert sein. Die Messmittel sind vorzugsweise zur Messung der Batterie- oder Umgebungstemperatur, zur Bestimmung des Innenwiderstands und zur Messung der Ruhespannung vorgesehen.

Die Aufgabe wird weiterhin durch ein Erzeugnis in Form eines verkörperten Computerprogrammes mit Programmcodemitteln gelöst, die zur Durchführung des oben beschriebenen Verfahrens ausgebildet sind, wenn das Computerprogramm mit einer Prozessoreinrichtung ausgeführt wird. Die Parameter der Umgebungs- und Batteriezustandsbedingungen, insbesondere die Temperatur, die Messgrößen zur Bestimmung der Ladezustandsparameter und des Innenwiderstands werden von dem Computerprogramm über geeignete Schnittstellen erfasst.

Die Erfindung wird nachfolgend anhand der beigefügten Zeichnungen näher erläutert. Es zeigen:

Figur 1 - Blockdiagramm der Aufteilung des Innenwiderstands in einen ersten und zweiten Widerstandsanteil mit zugeordneten Funktionen;

Figur 2 - Diagramm des spezifischen Widerstands von Blei in Abhängigkeit von der Temperatur als erste Funktion zur Bestimmung des ersten Widerstandsanteils;

Figur 3 - Diagramm der spezifischen Leitfähigkeit von Schwefelsäure in Abhängigkeit von der sich bei verschiedenen Säurekonzentrationen einstellenden Ruhespannung in einer Einzelzelle als Basisfunktionenschar zur Ermittlung der zweiten Funktion zur Bestimmung des zweiten Widerstandsanteils;

Figur 4 - Diagramm der spezifischen Leitfähigkeit von Schwefelsäure in Abhängigkeit von der Temperatur bei Ruhespannungen, die sich bei verschiedenen Säurekonzentrationen einstellen, als inverse zweite Funktion zur Bestimmung des zweiten Widerstandsanteils.

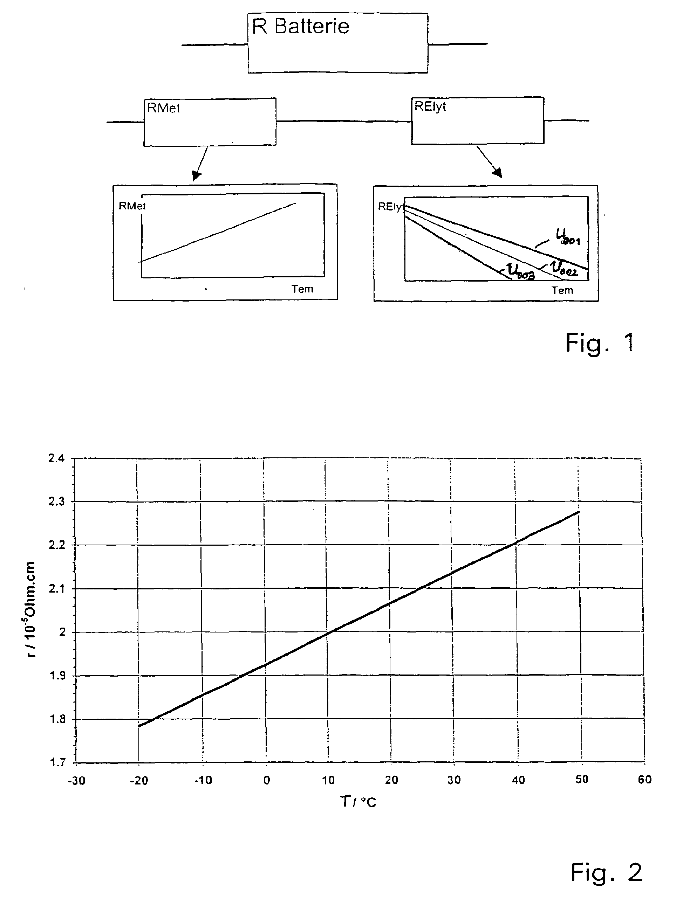

Die Figur 1 lässt ein Diagramm zur Aufteilung des Innenwiderstands $R_i$ einer Speicherbatterie in einen ersten Widerstandsanteil $R_{Met}$ und einen zweiten Widerstandsanteil $R_{Elyt}$ erkennen. Der erste Widerstandsanteil $R_{Met}$ repräsentiert den elektrischen Widerstand der Speicherbatterie für den Bereich der Elektronenleitung. Dieser erste Widerstandsanteil setzt sich damit zusammen aus den metallischen Widerständen einer Speicherbatterie, insbesondere der Polbolzen, Polbrükken, Polverbinder und Bleigitter eines Bleiakkumulators. Der zweite Widerstandsanteil repräsentiert den elektrischen Widerstand der Speicherbatterie für den Bereich der Ionenleitung, d. h. den Widerstandsbeitrag auf den Elektrolytwegen, insbesondere dem Elektrodenzwischenraum und den elektrolyterfüllten Elektrodenporen.

Bei Bleiakkumulatoren können bei dem ersten Widerstandsanteil weitere elektrische Widerstandsbeiträge vernachlässigt werden, insbesondere die Widerstandsbeiträge der positiven und negativen aktiven Materialien. Diese Widerstandsanteile können jedoch zusätzlich als weitere additive Widerstandsanteile entsprechend der ersten und zweiten Widerstandsanteile bei der Bestimmung des Innenwiderstands berücksichtigt werden.

Im Folgenden wird das erfindungsgemäße Verfahren am Beispiel eines Bleiakkumulators erläutert. Das Verfahren ist aber nicht auf Bleiakkumulatoren beschränkt, sondern kann auch in entsprechender Weise für andere Akkumulatorenarten angewendet werden.

Der Innenwiderstand $R_i$ berechnet sich somit zu

$$R_i = R_{Met} + R_{Elyt}.$$

Der erste Widerstandsanteil $R_{Met}$ wird vorzugsweise aus einem Faktor $Rfakt_{Met}$ und einer batterieunabhängigen ersten Funktion $r(T)$ von Parametern der Umgebungsbedingungen der Speicherbatterie nach der Formel

$$R_{Met} = Rfakt_{Met}(T_0) \cdot r(T)$$

berechnet werden, wobei $T_0$ eine Referenztemperatur und T die Umgebungsoder Batterietemperatur ist.

Der zweite Widerstandsanteil wird aus einem zweiten Faktor Lfakt und einer batterieunabhängigen zweiten Funktion $f(T,SOC)$ von Umgebungs- und Batteriezustandsbedingungen der Speicherbatterie nach der Formel

$$R_{Elyt} = 1/(Lfakt \cdot f(T,SOC))$$

bestimmt, wobei SOC ein Ladezustandsparameter ist, der den Ladezustand der Speicherbatterie beschreibt. Der Ladezustand SOC ist die Differenz zwischen der Nennkapazität der Speicherbatterie und der entnommenen Ladungsmenge bezogen auf die Nennkapazität. Beim Bleiakkumulator besteht zwischen der Ruhespannung $U_{00}$ und dem Ladezustand SOC ein eindeutiger und in weiten Bereichen linearer Zusammenhang, da die Ruhespannung $U_{oo}$ von der Elektrolytkonzentration und diese wiederum vom Ladezustand abhängt. Als Ladezustandsparameter kann daher anstelle des Ladezustands gleichwertig die Ruhespannung $U_{oo}$ gewählt werden. Dies hat den Vorteil, dass die Ruhespannung $U_{00}$ relativ einfach gemessen werden kann.

Aus den oben genannten Formeln ist erkennbar, dass der erste Widerstandsanteil $R_{Met}$ nicht vom Ladezustandsparameter SOC, sondern nur von der Temperatur T abhängt. Der zweite Widerstandsanteil $R_{Elyt}$ hängt hingegen von der Säurekonzentration ab und damit auch eindeutig von der Ruhespannung $U_{00}$ der Speicherbatterie als Maßzahl für die Elektrolytkonzentration bzw. von dem Ladezustand der Speicherbatterie. Der zweite Widerstandsanteil $R_{Elyt}$

hängt zudem relativ stark von der Temperatur T ab.

So zeigt die Figur 2 ein Diagramm des spezifischen Widerstands r von Blei in Abhängigkeit von der Temperatur T. Es ist erkennbar, dass ein linearer Zusammenhang zwischen dem spezifischen Bleiwiderstand und der Temperatur T besteht. Da der erste Widerstandsanteil $R_{Met}$ im wesentlichen durch die Widerstände der metallischen Bleiableiter der Bleibatterie bestimmt wird, kann aus dem temperaturabhängigen spezifischen Widerstand r unmittelbar die erste Funktion r(T) zur Berechnung des ersten Widerstandsanteils $R_{Met}$ abgeleitet werden. Als erste Funktion kann diese Funktion des spezifischen Widerstands r in Abhängigkeit von der Temperatur auch unmittelbar eingesetzt werden. Der erste Widerstandsanteil $R_{Met}$ berechnet sich dann aus dem Quotienten dieser ersten Funktion r(T) und einem ersten batterieabhängigen Faktor, der insbesonderem den Bleiquerschnitt wiedergibt.

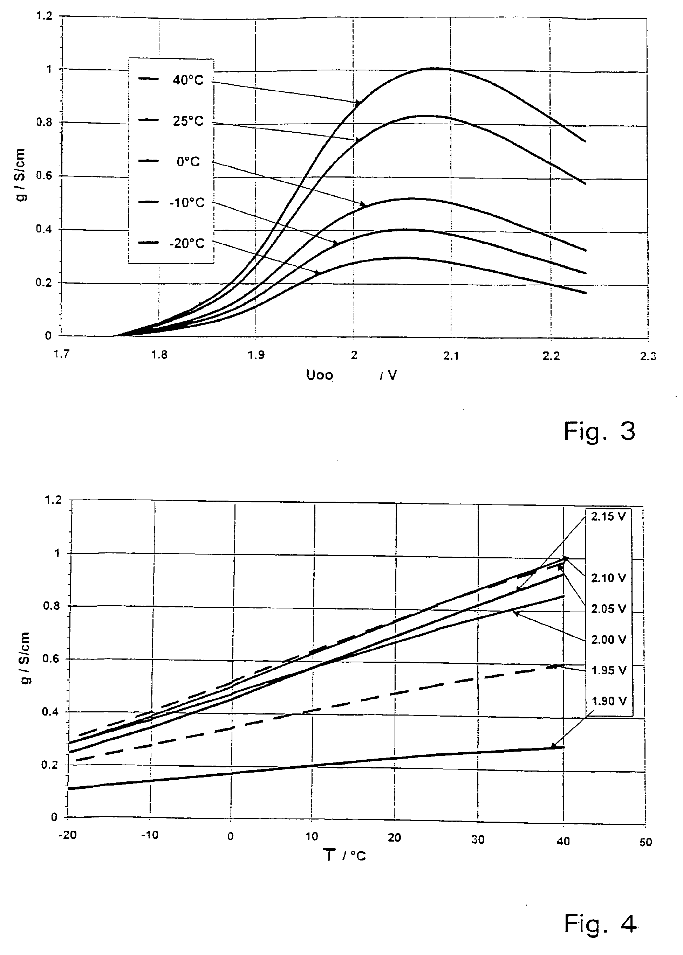

Die Figur 3 lässt die spezifische Leitfähigkeit g von Schwefelsäure in Abhängigkeit von der sich bei verschiedenen Säurekonzentrationen einstellenden Ruhespannung $U_{00}$ in einer Einzelzelle bei Temperaturen T im Bereich von -20°C bis 40°C erkennen. Der zweite Widerstandsanteil $R_{Elyt}$ ist im Wesentlichen durch diese temperatur- und säurekonzentrationsabhängige Leitfähigkeit der Schwefelsäure bestimmt.

Die Figur 4 lässt ein Diagramm der aus der Figur 3 abgeleiteten spezifischen Leitfähigkeit g von Schwefelsäure in Abhängigkeit von der Temperatur T bei verschiedenen Ruhespannungen $U_{00}$ in einer Einzelzelle im Bereich von 1,9 bis 2,15 V erkennen, die sich bei verschiedenen Säurekonzentrationen einstellen. Es wird deutlich, dass die temperaturabhängige spezifische Leitfähigkeit g für die verschiedenen Ruhespannungen $U_{00}$ jeweils annähernd als lineare Funktionen dargestellt werden können.

Es besteht also ein relativ einfacher und eindeutiger Zusammenhang zwischen der spezifischen Leitfähigkeit g und der Temperatur T sowie der Ruhespannung $U_{00}$, die die zweite Funktion f(T,SOC) zur Bestimmung des zweiten Widerstandsanteils in Abhängigkeit von den Parametern Temperatur T und Ladezustand SOC bzw. Ruhespannung $U_{00}$ beschreibt. Der zweite Widerstandsanteil $R_{Elyt}$ wird dabei aus einem batterieabhängigen zweiten Faktor Lfakt und dieser zweiten batterieunabhängigen Funktion f(T,SOC) berechnet.

Für einen 6-zelligen Bleiakkumulator wurden folgende Näherungen für die erste Funktion r(T[°C]) und f(T[°C], $U_{00}$[V]) gefunden:

$$r(T[°C]) = (1 + 0,00334 \cdot (T-25)]$$

und

$$f(T[°C])U_{00}[V]) =$$
$$(1,2487 \cdot (U_{00}-11,175)-0,4664 \cdot (U_{00}-11,175)^2) \cdot (1 + 0,0137 \cdot (T-25)),$$

wobei als Bezugspunkt für die Temperaturabhängigkeiten die Temperatur $T_0$=25°C gewählt wurde.

Der erste Faktor $Rfakt_{Met}$ und der zweite Faktor Lfakt sind Parameter, die die Speicherbatterie charakterisieren. Diese Werte können entweder vom Batteriehersteller angegeben oder im laufenden Batteriebetrieb erlernt werden. Das Erlernen der ersten und zweiten Faktoren hat den Vorteil, dass keine Vorkenntnisse über den Batterietyp, die Batteriegröße und den Hersteller erforderlich sind.

Mit Hilfe dieser ersten und zweiten Faktoren $Rfakt_{Met}$ und Lfakt und der Gleichung

$$R_i = Rfakt_{Met} (T_0) \cdot r(T) + 1/(Lfakt \cdot f(T,SOC/U_{00}))$$

kann nun der Innenwiderstand R für beliebige Temperaturen T und Ladezustandsparameter SOC mit Hilfe der ersten und zweiten Funktionen r(T), f(T,SOC) ohne weiteres vorhergesagt werden. Dies hat den Vorteil, dass die ersten und zweiten Funktionen r(T), f(T,SOC) relativ einfach, eindeutig und insbesondere batterieunabhängig sind.

Im Folgenden wird ein Verfahren zur Ermittlung des ersten Faktors $Rfakt_{Met}$ und des zweiten Faktors Lfakt erläutert.

In einem ersten Schritt wird der Innenwiderstand $R_1$, die Batterie- oder Umgebungstemperatur $T_1$ und die Ruhespannung $U_{001}$ gemessen.

Dann wird ein Wert für den ersten Faktor $Rfakt_{Met}(T_0)$ geschätzt.

Anschließend wird mit der sich aus den oben beschriebenen Gleichungen ergebenen Gleichung

$$(1) \qquad Lfakt = 1/\left(\left[R_i - Rfakt_{Met}(T_0) \cdot r(T)\right] \cdot f(T, U_{00})\right)$$

der zweite Faktor Lfakt berechnet.

Mit dem geschätzten ersten Faktor $Rfakt_{Met}$ für die Referenztemperatur $T_0$ und dem berechneten zweiten Faktor Lfakt kann nun eine erste noch relativ ungenaue Prognose zu dem künftigen Batterieverhalten bei anderen Umgebungsund/oder Batteriezustandsbedingungen durchgeführt werden.

In einem nächsten Schritt wird bei veränderten Umgebungs- und/oder Batteriezustandsbedingungen, beispielsweise einer unterschiedlichen Umgebungs- oder Batterietemperatur T, erneut der Innenwiderstand $R_2$, die Batterie- oder Umgebungstemperatur $T_2$ und die Ruhespannung $U_{002}$ gemessen.

Anschließend wird mit der folgenden Gleichung

$$(2) \qquad Rfakt_{Met}(T_0) = \frac{R_1 \cdot f(T_1, U_{001}) - R_2 \cdot f(T_2, U_{002})}{r(T_1) \cdot f(T_1, U_{001}) - r(T_2) \cdot f(T_2, U_{002})}$$

mit den beiden durchgeführten Messungen ein verbesserter Wert des ersten Faktors $Rfakt_{Met}(T_0)$ berechnet werden.

Unter Anwendung der oben genannten Gleichung (1) und des neu berechneten ersten Faktors $Rfakt_{Met}(T_0)$ wird dann der zugehörige zweite Faktor Lfakt berechnet.

Zur Erhöhung der Genauigkeit können die Messungen und das Einsetzen der Messergebnisse in die Gleichung (2) und (1) beliebig oft wiederholt werden.

Auf diese Weise können die die Speicherbatterie charakterisierenden ersten und zweiten Faktoren $Rfakt_{Met}$, Lfakt auf einfache Weise ermittelt werden und es ist eine recht genaue Prognose des Innenwiderstands $R_i$ bei anderen Umgebungsund Batteriezuständen möglich.

Wesentlich für diese itterative Ermittlung der ersten und zweiten Faktoren $Rfakt_{Met}$, Lfakt ist, dass bei den verschiedenen Messungen die Umgebung- und/oder Batteriezustandsbedingungen, wie Batterie- oder Umgebungstemperatur T bzw. Ladezustand, deutlich voneinander unterschiedlich sind.

Zur Berücksichtigung von Alterungseffekten sollte das Ermitteln der ersten und zweiten Faktoren $Rfakt_{Met}$, Lfakt beispielsweise intervallweise wiederholt werden.

Da immer mit Unsicherheiten, z. B. bei der Meßgenauigkeit der Meßgeräte, zu rechnen ist und damit Streuungen berücksichtigt werden müssen, sollten die ermittelten ersten und zweiten Faktoren $Rfakt_{Met}$, Lfakt nicht direkt übernommen werden. Vielmehr ist es vorteilhaft, wenn der aktuell ermittelte Faktor mit einem früher ermittelten Faktor gewichtet korreliert wird. Beispielsweise kann der erste Faktor nach der Gleichung

$$Rfakt_{Met}(T_0) = Rfakt_{Met1}(T_0) + \left(Rfakt_{Met0}(T_0) - Rfakt_{Met1}(T_0)\right) \cdot GEW$$

und der zweite Faktor nach der Formel

$$Lfakt = \left(Lfakt_1 + \left(Lfakt_0 - Lfakt_1\right)\right) \cdot GEW$$

berechnet werden, wobei der Index 1 den bei der aktuellen Messung ermittelten Faktor und der Index 0 ein bei einer früheren Messung ermittelter Faktor kennzeichnet. Der Gewichtungsfaktor GEW sollte je nach Zuverlässigkeit der Widerstandsermittlung als Wert zwischen 0 und 1 gewählt werden. Beispielsweise sollte der Gewichtungsfaktor um so größer gewählt werden, je geringer die Messungenauigkeit bezüglich der Batteriespannung und des Batteriestroms i ist. Wenn z. B. bei einem Strom-Zeit-Profil i(T) eine große Zahl von zusammengehörigen Wertepaaren $U_i$ und $I_i$ bestimmt wurden und daraus zahlreiche Innenwiderstandswerte $R_K$ berechnet werden konnten, so kann dem daraus gewonnenen Faktor $Rfakt_{Met}(T_0)$ ein höherer Gewichtungsfaktor zugeordnet werden, als wenn sich die Bestimmung auf ein einziges Wertepaar von Spannungs-/Stromänderung stützt. Ebenso kann die Gewichtung beispielsweise um so größer gewählt werden, je mehr die Temperatur T oder die Ladezustandsparameter SOC zum Zeitpunkt der Messungen des Innenwiderstands $R_i$ voneinander abweichen.

Analoges gilt für den zweiten Faktor Lfakt.

Auf diese Weise ist die Abhängigkeit des Innenwiderstandes $R_i$ der Speicherbatterie vom Ladezustand der Temperatur erlernbar, auch wenn die Größe und Bauart der Speicherbatterie nicht bekannt ist. Dies ist besonders vorteilhaft in Systemen, bei denen ein Austausch der Speicherbatterie gegen eine andere nicht baugleiche Speicherbatterie oder durch ungeschultes Personal möglich ist, wie z. B. in einem Kraftfahrzeug.

Mit dem Verfahren zum Erlernen des ersten und zweiten Faktors können weiterhin Alterungseffekte der Speicherbatterie erkannt werden, beispielsweise wenn in einer ersten Betriebsperiode die ersten und zweiten Faktoren $\text{Rfakt}_{Met}$, Lfakt bestimmt werden, um die Speicherbatterie zu charakterisieren. Wenn dann in einer zweiten Betriebsperiode festgestellt wird, dass die ersten und zweiten Faktoren $\text{Rfakt}_{Met}$, Lfakt annähernd konstant bleiben und in einer dritten Periode erkannt wird, dass sich die ersten und zweiten Faktoren $\text{Rfakt}_{Met}$, Lfakt ändern, insbesondere systematisch, kann auf eine Alterung geschlossen werden.

Das Verfahren zur Vorhersage des Innenwiderstands $R_i$ kann mit anderen Verfahren verknüpft werden, die das Betriebsverhalten der Speicherbatterien in anderen Ladezuständen SOC und/oder bei anderen Temperaturen T vorhersagen. Beispielsweise bei Verwendung eines elektrischen Ersatzschaltbildes, das einen ohmschen Widerstandsanteil enthält, kann der vorhergesagte Innenwiderstand $R_i$ für angenommene Umgebungs- und/oder Batteriezustandsbedingungen in das Ersatzschaltbild eingesetzt werden. Mit Hilfe des Ersatzschaltbilds kann dann beispielsweise das Spannungsverhalten der Speicherbatterie vorhergesagt werden.

Neben dem ersten Widerstandsanteil $R_{Met}$ und dem zweiten Widerstandsanteil $R_{Elyt}$ können noch weitere Widerstandsanteile auftreten, die im Falle einer Batterie meist vernachlässigbar sind. So kann beispielsweise ein dritter Widerstandsanteil den elektrischen Widerstand der Speicherbatterie für den Bereich der positiven aktiven Massen und ein vierter Widerstandsanteil den elektrischen Widerstand der Speicherbatterie für den Bereich der negativen aktiven Massen sein. Diese weiteren Widerstandsanteile zeigen im Allgemeinen ebenfalls eine eigene charakteristische Abhängigkeit von der Batterie- oder Umgebungstemperatur und dem Ladezustand SOC der Speicherbatterie. Insbesondere für Lithium-Ionen-Batterien ist der dritte und vierte Widerstandsanteil signifikant und sollte daher in entsprechender Weise mit einem batterieabhängigen Faktor und einer batterieunabhängigen Funktion bestimmt werden. Dabei wird der funktionale Zusammenhang des zugehörigen Faktors von Umgebungs- und Batteriezustandsparametern formuliert und die Parameter mit angenommenen Startwerten und einer Mindestanzahl von voneinander unabhängigen Messungen sukzessive bestimmt.

**Patentansprüche**

1. Verfahren zur Vorhersage des Innenwiderstandes ($R_i$) einer Speicherbatterie bei angenommenen Umgebungs- und Batteriezustandsbedingungen, **gekennzeichnet durch**

   - Aufteilen des Innenwiderstandes ($R_i$) in einen ersten Widerstandsanteil ($R_{Met}$), der den elektrischen Widerstand der Speicherbatterie für den Bereich der Elektronenleitung repräsentiert, und einen zweiten Widerstandsanteil ($R_{Elyt}$), der den elektrischen Widerstand der Speicherbatterie für den Bereich der Ionenleitung repräsentiert,
   - Ermitteln der bei den angenommenen Umgebungs- und Batteriezustandsbedingungen zu erwartenden ersten und zweiten Widerstandsanteile ($R_{Mat}$, $R_{Elyt}$) jeweils in Abhängigkeit von Parametern der angenommenen Umgebungs- und Batteriezustandsbedingungen, und
   - Ermitteln eines ersten und zweiten Faktors **durch** Bestimmen von Parametern und Innenwiderständen ($R_i$) bei mindestens zwei voneinander verschiedenen Umgebungs- und/oder Batteriezustandsbedingungen.

   wobei der erste Faktor ($\text{Rfakt}_{Met}$) für den ersten Widerstandsanteil ($R_{Met}$) und der zweite Faktor (LFakt) für den zweiten Widerstandsanteil ($R_{Elyt}$) in Abhängigkeit von dem Typ der Speicherbatterie festgelegt oder ermittelt wird und der erste Widerstandsanteil ($R_{Met}$) aus dem ersten Faktor ($\text{Rfakt}_{Met}$) und einer batterieunabhängigen ersten Funktion (r(T)) von Parametern der Umgebungsbedingungen der Speicherbatterie sowie der zweite Widerstandsanteil ($R_{Elyt}$) aus dem zweiten Faktor (Lfakt) und einer batterieunabhängigen zweiten Funktion (f(TSOC)) von Umgebungs- und Batteriezustandsbedingungen der Speicherbatterie bestimmt wird.

2. Verfahren nach Anspruch 1, **dadurch gekennzeichnet, dass** als Parameter zur Ermittlung des ersten Widerstandsanteils ($R_{Met}$) eine von der Batterietemperatur abhängige Größe und als Parameter zur Ermittlung des zweiten Widerstandsanteils ($R_{Elyt}$) eine von der Batterietemperatur und dem Ladezustand (SOC) der Speicherbatterie abhängige Größe eingesetzt wird.

3. Verfahren nach einem der vorhergehenden Ansprüche, **gekennzeichnet durch** Ermitteln der Batterie- oder Umgebungstemperatur als Temperaturparameter, der Ruhespannung ($U_{00}$) der Speicherbatterie als Ladezustandsparameter, und des Innenwiderstandes ($R_i$) der Speicherbatterie.

4. Verfahren nach einem der vorhergehenden Ansprüche, **gekennzeichnet durch**

   a) Schätzen des ersten Faktors;
   b) Bestimmen des zweiten Faktors in Abhängigkeit von dem geschätzten ersten Faktor und von Parametern, die bei ersten Umgebungs- und Batteriezustandsbedingungen ermittelt wurden;
   c) Bestimmen eines korrigierten ersten Faktors bei veränderten zweiten Umgebungs- und/oder Batteriezustandsbedingungen in Abhängigkeit von dem vorher ermittelten zweiten Faktor und von den bei zweiten Umgebungs- und Batteriezustandsbedingungen ermittelten Parametern;
   d) Bestimmen des zweiten Faktors in Abhängigkeit von dem korrigierten ersten Faktor und den bei den ersten oder zweiten Umgebungs- und Batteriezustandsbedingungen ermittelten Parametern.

5. Verfahren nach Anspruch 4, **gekennzeichnet durch** Wiederholen der Schritte c) und d).

6. Verfahren nach einem der vorhergehenden Ansprüche, **gekennzeichnet durch** Ermitteln des ersten Widerstandsanteils ($R_{Met}$) nach der Formel:

$$R_{Met} = Rfakt_{Met}(T_0) \cdot r(T)$$

wobei $Rfakt_{Met}(T_0)$ der erste Faktor bei einer Referenztemperatur $T_0$ und $r(T)$ eine von der Batterietemperatur T abhängige erste Funktion ist.

7. Verfahren nach Anspruch 6, **dadurch gekennzeichnet, dass** die erste Funktion als Gleichung:

$$r(T) = 1 + k \cdot (T - T_0) + l(T - T_0)^2$$

mit den Konstanten k und I definiert ist.

8. Verfahren nach einem der vorhergehenden Ansprüche, **gekennzeichnet durch** Ermitteln des zweiten Widerstandsanteils ($R_{Elyt}$) nach der Formel:

$$R_{Elyt} = \frac{1}{Lfakt \cdot f(T, SOC)},$$

wobei Lfakt der zweite Faktor und $f(T, SOC)$ eine von der Batterietemperatur T und dem Ladezustand SOC der Speicherbatterie abhängige zweite Funktion ist.

9. Verfahren nach Anspruch 8, **dadurch gekennzeichnet, dass** die zweite Funktion ($f(T, SOC)$) als Gleichung

$$f(T, SOC) = (a + b \cdot SOC + c \cdot SOC^2) \cdot (1 + d(T - T_0) + e(T - T_0)^2)$$

mit den Konstanten a, b, c, d und e und der Referenztemperatur $T_0$ definiert ist.

10. Verfahren nach einem der vorhergehenden Ansprüche, **gekennzeichnet durch** Bestimmen eines aktuellen ersten Faktors bei aktuellen Umgebungs- und Batteriezustandsbedingungen und Berechnen eines korrigierten ersten Faktors ($Rfakt_{Met}$) aus dem aktuellen ersten Faktor und mindestens einem gewichteten vorherbestimmten ersten Faktor.

**11.** Verfahren nach einem der vorhergehenden Ansprüche, **gekennzeichnet durch** Bestimmen eines aktuellen zweiten Faktors bei aktuellen Umgebungs- und Batteriezustandsbedingungen und Berechnen eines korrigierten zweiten Faktors (LFakt) aus dem aktuellen zweiten Faktor und einem gewichteten vorherbestimmten zweiten Faktor.

**12.** Verfahren nach einem der vorhergehenden Ansprüche, **gekennzeichnet durch** Berechnen des ersten Faktors ($Rfakt_{Met}$) bei der Referenztemperatur ($T_0$) nach der Formel:

$$Rfakt_{Met}(T_0) = \frac{R_1 \cdot f(T_1, SOC_1) - R_2 \cdot f(T_2, SOC_2)}{r(T_1) \cdot f(T_1, SOC_1) - r(T_2) \cdot f(T_2, SOC_2)}$$

wobei $R_1$ der Innenwiderstand, $T_1$ die Batterie- oder Umgebungstemperatur und $SOC_1$ der Ladezustandsparameter zum Zeitpunkt einer ersten Messung bei ersten Umgebungs- und Batteriezustandsbedingungen und $R_2$ der Innenwiderstand, $T_2$ die Batterie- oder Umgebungstemperatur und $SOC_2$ der Ladezustandsparameter zum Zeitpunkt einer zweiten Messung bei zweiten Umgebungs- und Batteriezustandsbedingungen sind.

**13.** Verfahren nach Anspruch 12, **gekennzeichnet durch** Berechnen des zweiten Faktors ($L_{fakt}$) nach der Formel

$$Lfakt = 1 / \left( [R_i - Rfakt_{Met}(T_0) \cdot r(T_i)] \cdot f(T_i, SOC_i) \right),$$

wobei ($R_i$) der Innenwiderstand ($T_i$) die Batterie- oder Umgehungstemperatur und ($SOC_i$) der Ladezustandsparameter zum Zeitpunkt einer Messung i sind.

**14.** Verfahren nach einem der vorhergehenden Ansprüche, **gekennzeichnet durch** Aufteilen des Innenwiderstandes ($R_i$) in einen dritten Widerstandsanteil ($R_{M+}$) für den Bereich der positiven aktiven Masse der Speicherbatterie und/ oder in einen vierten Widerstandsanteil ($R_{M-}$) für den Bereich der negativen aktiven Masse der Speicherbatterie und Ermitteln der Dritten und/oder vierten Widerstandsanteile ($R_{M+}$, $R_{M-}$) jeweils mit einen zugeordneten Faktor und mit einer Funktion von Parametern der Umgebungs- und Batteriezustandsbedingungen.

**15.** Verfahren nach einem der vorhergehenden Ansprüche, **gekennzeichnet durch** Vorhersage des Zustands der Speicherbatterie in Abhängigkeit von dem vorhergesagten Innenwiderstand ($R_i$).

**16.** Verfahren nach Anspruch 15, **gekennzeichnet durch** Vorhersage des Verschleißes, der Leistungs- oder der Funktionsfähigkeit.

**17.** Überwachungseinrichtung für Speicherbatterien mit Messmitteln zur Messung von Parametern der Umgebungs- und Betriebszustandsbedingungen der Speicherbatterie und mit Rechenmitteln, **dadurch gekennzeichnet, dass** die Rechenmittel zur Durchführung aller Schritte des Verfahrens nach einem der vorhergehenden Ansprüche ausgebildet sind.

**18.** Überwachungseinrichtung nach Anspruch 17, **dadurch gekennzeichnet, dass** Messmittel zur Messung der Batterie- oder Umgebungstemperatur, zur Bestimmung des Innenwiderstandes ($R_i$) und zur Messung der Ruhespannung ($U_{00}$) vorgesehen sind.

**19.** Erzeugnis in Form eines verkörperten Computerprogramms mit Programmcodemitteln, **dadurch gekennzeichnet, dass** die Programmcodemittel zur Durchführung aller Schritte des Verfahrens nach einem der Ansprüche 1 bis 17 ausgebildet sind, wenn das Computerprogramm mit einer Prozessoreinrichtung ausgeführt wird.

**20.** Erzeugnis nach Anspruch 19, **dadurch gekennzeichnet, dass** das Computerprogramm als auf einem Datenträger gespeicherte Programmdatei oder ein in einem Datennetzwerk übertragener Programmdatenstrom verkörpert ist.

**Claims**

1.  Method for prediction of the internal resistance ($R_i$) of an energy storage battery in assumed environmental and battery state conditions,
    **characterized by**

    - subdivision of the internal resistance ($R_i$) into a first resistance component ($R_{Met}$) which represents the electrical resistance of the energy storage battery for the region of electron conduction, and a second resistance component ($R_{Elyt}$) which represents the electrical resistance of the energy storage battery for the region of ion conduction, and
    - determination of the first and second resistance components ($R_{Met}$, $R_{Elyt}$) to be expected for the assumed environmental and battery state conditions, in each case as a function of parameters of the assumed environmental and battery state conditions, and determination of a first and second factors by determination of parameters and internal resistances ($R_i$) for at least two environmental and/or battery state conditions which differ from one another, wherein the first factor ($Rfact_{Met}$) for the first resistance component ($R_{Met}$) and the second factor (LFact) for the second resistance component ($R_{Elyt}$) are defined or determined as a function of the type of energy storage battery, and the first resistance component ($R_{Met}$) is determined from the first factor ($Rfact_{Met}$) and from a battery-independent first function ($r(T)$) of parameters relating to the environmental conditions for the energy storage battery, and the second resistance component ($R_{Elyt}$) is determined from the second factor (Lfact) and from a battery-independent second function (f(TSOC)) relating to the environmental and battery state conditions for the energy storage battery.

2.  Method according to Claim 1, **characterized in that** a variable which is dependent on the battery temperature is used as a parameter for determination of the first resistance component ($R_{Met}$), and a variable which is dependent on the battery temperature and on the state of charge (SOC) of the energy storage battery is used as a parameter for determination of the second resistance component ($R_{Elyt}$).

3.  Method according to one of the preceding claims, **characterized by** determination of the battery or environmental temperature as a temperature parameter, of the no-load voltage ($U_{00}$) of the energy storage battery as a state of charge parameter, and of the internal resistance ($R_i$) of the energy storage battery.

4.  Method according to one of the preceding claims, **characterized by**

    a) estimation of the first factor;
    b) determination of the second factor as a function of the estimated first factor and of parameters which have been determined for first environmental and battery state conditions;
    c) determination of a corrected first factor for changed second environmental and/or battery state conditions as a function of the previously determined second factor and of the parameters determined for the second environmental and battery state conditions;
    d) determination of the second factor as a function of the corrected first factor and of the parameters determined for the first or second environmental and battery state conditions.

5.  Method according to Claim 4, **characterized by** repetition of steps c) and d).

6.  Method according to one of the preceding claims, **characterized by** determination of the first resistance component ($R_{Met}$) using the formula:

$$R_{Met} = Rfact_{Met}(T_0) \cdot r(T)$$

where $Rfact_{Met}(T_0)$ is the first factor for a reference temperature $T_0$ and $r(T)$ is a first function which is dependent on the battery temperature T.

7.  Method according to Claim 6, **characterized in that** the first function is defined as an equation:

$$r(T) = 1+k\cdot(T-T_0)+1(T-T_0)^2$$

with the constants k and l.

8. Method according to one of the preceding claims, **characterized by** determination of the second resistance component ($R_{Elyt}$) using the formula:

$$R_{Elyt} = \frac{1}{Lfact \cdot f(T, SOC)}$$

where Lfact is the second factor and f(T, SOC) is a second function which is dependent on the battery temperature T and on the state of charge SOC for the energy storage battery.

9. Method according to Claim 8, **characterized in that** the second function (f(T, SOC)) is defined as an equation

$$f(T, SOC) = (a+b\cdot SOC+c\cdot SOC^2)\cdot(1+d(T-T_0)+e(T-T_0)^2)$$

with the constants a, b, c, d and e and the reference temperature $T_0$.

10. Method according to one of the preceding claims, **characterized by** determination of an instantaneous first factor for instantaneous environmental and battery state conditions and calculation of a corrected first factor ($Rfact_{Met}$) from the instantaneous first factor and from at least one weighted previously determined first factor.

11. Method according to one of the preceding claims, **characterized by** determination of an instantaneous second factor for instantaneous environmental and battery state conditions and calculation of a corrected second factor (LFact) from the instantaneous second factor and from a weighted previously determined second factor.

12. Method according to one of the preceding claims, **characterized by** calculation of the first factor ($Rfact_{Met}$) for the reference temperature (To) using the formula:

$$Rfact_{Met}(T_0) = \frac{R_1\cdot f(T_1,SOC_1)-R_2\cdot f(T_2,SOC_2)}{r(T_1)\cdot f(T_1,SOC_1)-r(T_2)\cdot f(T_2,SOC_2)},$$

where $R_1$ is the internal resistance, $T_1$ is the battery or environmental temperature and $SOC_1$ is the state of charge parameter at the time of a first measurement for the first environmental and battery state conditions, and $R_2$ is the internal resistance, $T_2$ is the battery or environmental temperature and $SOC_2$ is the state of charge parameter at the time of a second measurement for the second environmental and battery state conditions.

13. Method according to Claim 12, **characterized by** calculation of the second factor ($L_{fact}$) using the formula

$$Lfact=1/([R_i-Rfact_{Met}(T_0)\cdot r(T_i)]\cdot f(T_i,SOC_i),$$

where ($R_i$) is the internal resistance, ($T_i$) is the battery or environmental temperature, and ($SOC_i$) is the state of charge parameter at the time of a measurement i.

14. Method according to one of the preceding claims, **characterized by** subdivision of the internal resistance ($R_i$) into a third resistance component ($R_{M+}$) for the region of the positive active mass of the energy storage battery and/or into a fourth resistance component ($R_{M-}$) for the region of the negative active mass of the energy storage battery and determination of the third and/or fourth resistance components ($R_{M+}$, $R_{M-}$) in each case using an associated factor and using a function of parameters for the environmental and battery state conditions.

15. Method according to one of the preceding claims, **characterized by** prediction of the state of the energy storage battery as a function of the predicted internal resistance ($R_i$).

16. Method according to Claim 15, **characterized by** prediction of the wear, of the performance or of the functionality.

17. Monitoring device for energy storage batteries having measurement means for measurement of parameters for the environmental and operating state conditions of the energy storage battery, and having computation means, **characterized in that** the computation means are designed to carry out all steps of the method according to one of the preceding claims.

18. Monitoring device according to Claim 17, **characterized in that** measurement means are provided for measurement of the battery or environmental temperature, for determination of the internal resistance ($R_i$), and for measurement of the no-load voltage ($U_{00}$).

19. Product in the form of an embodied computer program with program code means, **characterized in that** the program code means are designed to carry out the method according to one of Claims 1 to 17 when the computer program is run using a processor device.

20. Product according to Claim 19, **characterized in that** the computer program is embodied as a program file which is stored on a data storage medium, or as a program data stream which is transmitted in a data network.

**Revendications**

1. Procédé de prédiction de la résistance interne ($R_i$) d'une batterie d'accumulateurs dans des conditions environnantes et d'état de la batterie supposées,
**caractérisé par**

   - la répartition de la résistance interne ($R_i$) en une première fraction de résistance ($R_{Met}$) qui représente la résistance électrique de la batterie d'accumulateurs pour le domaine de la conduction par électrons, et en une deuxième fraction de résistance ($R_{Elyt}$) qui représente la résistance électrique de la batterie d'accumulateurs pour le domaine de la conduction par ions,
   - la détermination des premières et deuxièmes fractions de résistance ($R_{Met}$, $R_{Elyt}$) à attendre avec les conditions environnantes et d'état de la batterie supposées respectivement en fonction de paramètres des conditions environnantes et d'état de la batterie supposées, et
   - la détermination d'un premier et d'un deuxième facteur en déterminant des paramètres et des résistances internes ($R_i$) avec au moins deux conditions environnantes et/ou d'état de 1a batterie différentes l'une de l'autre,

   selon lequel
   le premier facteur ($Rfakt_{Met}$) est défini ou déterminé pour la première fraction de résistance ($R_{Met}$) et le deuxième facteur (LFakt) pour la deuxième fraction de résistance ($R_{Elyt}$) en fonction du type de batterie d'accumulateurs, on détermine 1a première fraction de résistance ($R_{Met}$) à partir du premier facteur ($Rfakt_{Met}$) et d'une première fonction ($r(T)$), indépendante de la batterie, de paramètres des conditions environnantes de la batterie d'accumulateurs, et on détermine la deuxième fraction de résistance ($R_{Elyt}$) à partir du deuxième facteur (Lfakt) et d'une deuxième fonction ($f(TSOC)$), indépendante de la batterie, de conditions environnantes et d'état de la batterie d'accumulateurs.

2. Procédé selon la revendication 1,
**caractérisé en ce que**
comme paramètres pour déterminer la première fraction de résistance ($R_{Met}$), on utilise une grandeur indépendante de la température de la batterie et, comme paramètres pour déterminer la deuxième fraction de résistance ($R_{Elyt}$), une grandeur dépendant de la température de la batterie et de l'état de charge (SOC) de la batterie d'accumulateurs.

3. Procédé selon l'une quelconque des revendications précédentes,
**caractérisé en ce qu'**
on détermine la température de la batterie et environnante en tant que paramètre de température, la tension au repos (Uoo) de la batterie d'accumulateurs en tant que paramètres d'état de charge, et la résistance interne ($R_i$) de la batterie d'accumulateurs.

4. Procédé selon l'une quelconque des revendications précédentes,
**caractérisé par**

a) l'estimation du premier facteur ;
b) la détermination du deuxième facteur en fonction du premier facteur estimé et de paramètres déterminés avec des premières conditions environnantes et d'état de la batterie;
c) la détermination d'un premier facteur corrigé avec des deuxièmes conditions environnantes et/ou d'état de la batterie modifiées en fonction du deuxième facteur déterminé auparavant et des paramètres déterminés avec des deuxièmes conditions environnantes et d'état de la batterie ; et
d) la détermination du deuxième facteur en fonction du premier facteur corrigé et des paramètres déterminés avec les premières et deuxièmes conditions environnantes et d'état de la batterie.

5. Procédé selon la revendication 4,
**caractérisé par**
la répétition des étapes c) et d).

6. Procédé selon l'une quelconque des revendications précédentes,
**caractérisé par**
la détermination de la première fraction de résistance ($R_{Met}$) selon la formule :

$$R_{Met} = Rfakt_{Met}\,(T_0) \cdot r(T)$$

dans laquelle $Rfakt_{Met}\,(T_0)$ est le premier facteur à une température de référence $T_0$, et $r(T)$ est une première fonction dépendant de la température de la batterie T.

7. Procédé selon la revendication 6,
**caractérisé en ce que**
la première fonction est définie en tant qu'équation :

$$r(T) = 1 + k \cdot (T - T_0) + l(T - T_0)^2$$

avec les constantes k et 1.

8. Procédé selon l'une quelconque des revendications précédentes,
**caractérisé par**
la détermination de la deuxième fraction de résistance ($R_{Elyt}$) selon la formule :

$$R_{Elyt} = \frac{1}{Lfakt \cdot f(T,SOC)},$$

dans laquelle Lfakt est le deuxième facteur et $f(T, SOC)$ est une deuxième fonction dépendant de la température de la batterie T et de l'état de charge SOC de la batterie d'accumulateurs.

9. Procédé selon la revendication 8,
**caractérisé en ce que**
la deuxième fonction ($f(T, SOC)$) est définie en tant qu'équation

$$f(T, SOC) = (a + b \cdot SOC + c \cdot SOC^2) \cdot (1 + d(T - T_0) + e(T - T_0)^2)$$

avec les constantes a, b, c, d et e et la température de référence $T_0$.

10. Procédé selon l'une quelconque des revendications précédentes,
**caractérisé par**
la détermination d'un premier facteur actuel avec les conditions environnantes et d'état de la batterie actuelles et le calcul d'un premier facteur corrigé ($Rfakt_{Met}$) à partir du premier facteur actuel et d'au moins un premier facteur préalablement déterminé pondéré.

11. Procédé selon l'une quelconque des revendications précédentes,
**caractérisé par**
la détermination d'un deuxième facteur actuel avec les conditions environnantes et d'état de la batterie actuelles, et le calcul d'un deuxième facteur corrigé (LFakt) à partir du deuxième facteur actuel et d'un deuxième facteur préalablement déterminé pondéré.

12. Procédé selon l'une quelconque des revendications précédentes,
**caractérisé par**
le calcul du premier facteur ($Rfakt_{Met}$) à la température de référence ($T_0$) selon la formule

$$Rfakt_{Met}(T0) = \frac{R_1 \cdot f(T_1, SOC_1) - R_2 \cdot f(T_2, SOC_2)}{r(T_1) \cdot f(T_1, SOC_1) - r(T_2) \cdot f(T_2, SOC_2)}$$

dans laquelle $R_1$ est la résistance interne, $T_1$ la température de la batterie ou environnante, $SOC_1$ le paramètre d'état de charge au moment d'une première mesure avec des premières conditions environnantes et d'état de la batterie, $R_2$ la résistance interne, $T_2$ la température de la batterie et environnante, et $SOC_2$ le paramètre d'état de charge au moment d'une deuxième mesure avec des deuxièmes conditions environnantes et d'état de la batterie.

13. Procédé selon la revendication 2,
**caractérisé par**
le calcul du deuxième facteur ($L_{fakt}$) selon la formule

$$Lfakt = 1 / ([R_i - Rfakt_{Met}(T_0) \cdot r(T_i)] \cdot f(T_i, SOC_i),$$

dans laquelle ($R_i$) est la résistance interne, ($T_i$) la température de la batterie ou environnante et ($SOC_i$) le paramètre d'état de charge au moment d'une mesure i.

14. Procédé selon l'une quelconque des revendications précédentes,
**caractérisé par**
la répartition de la résistance interne ($R_i$) en une troisième fraction de résistance ($R_{M+}$) pour le domaine de la masse active positive de la batterie d'accumulateurs et/ou en une quatrième fraction de résistance ($R_{M-}$) pour le domaine de la masse active négative de la batterie d'accumulateurs, et la détermination de la troisième et/ou quatrième fractions de résistance ($R_{M+}$, $R_{M-}$) respectivement avec un facteur associé et avec une fonction de paramètres des conditions environnantes et d'état de la batterie.

15. Procédé selon l'une quelconque des revendications précédentes,
**caractérisé par**
la prédiction de l'état de la batterie d'accumulateurs en fonction de la résistance interne ($R_i$) prédite.

16. Procédé selon la revendication 5,
**caractérisé par**
la prédiction de l'usure, de la performance ou du bon fonctionnement.

**17.** Dispositif de surveillance de batteries d'accumulateurs comportant des moyens de mesure pour mesurer des paramètres des conditions environnantes et d'état de fonctionnement de la batterie d'accumulateurs et comportant des moyens de calcul,
**caractérisé en ce que**
les moyens de calcul sont conçus pour la réalisation de toutes les étapes du procédé selon l'une quelconque des revendications précédentes.

**18.** Dispositif de surveillance selon la revendication 17,
**caractérisé en ce qu'**
on prévoit des moyens de mesure pour mesurer la température de la batterie ou environnante, pour déterminer la résistance interne ($R_i$) et pour mesurer la tension de repos (Uoo).

**19.** Produit sous forme de programme informatique matérialisé avec des moyens d'encodage,
**caractérisé en ce que**
les moyens d'encodage sont conçus pour réaliser toutes les étapes du procédé selon l'une quelconque des revendications 1 à 17, lorsque le programme informatique est exécuté avec un processeur.

**20.** Produit selon la revendication 19,
**caractérisé en ce que**
le programme informatique est matérialisé sous forme de fichier programme enregistré sur un support de données ou de flux de données programme transmis dans un réseau de données.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19847648 A1
- WO 03001224 A1